(19) Europäisches Patentamt
European Patent Office
Office européen des brevets

(11) EP 2 775 526 A2

(12) EUROPEAN PATENT APPLICATION

(43) Date of publication:
10.09.2014 Bulletin 2014/37

(51) Int Cl.:
H01L 29/04 (2006.01)          H01L 29/16 (2006.01)
H01L 29/32 (2006.01)

(21) Application number: 14158185.0

(22) Date of filing: 06.03.2014

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(30) Priority: 07.03.2013 JP 2013045725

(71) Applicant: Kabushiki Kaisha Toshiba
Tokyo (JP)

(72) Inventors:
• Ota, Chiharu
  Tokyo (JP)
• Nishio, Johji
  Tokyo (JP)
• Shinohe, Takashi
  Tokyo (JP)

(74) Representative: Granleese, Rhian Jane
Marks & Clerk LLP
90 Long Acre
London WC2E 9RA (GB)

(54) **Semiconductor substrate and semiconductor device**

(57) According to one embodiment, a semiconductor substrate (100) includes a substrate (10) and a semiconductor layer (20). The substrate (10) has a first surface (10a) and containing a silicon carbide. The semiconductor layer (20) is provided on the first surface (10a). The semiconductor layer (20) has a thickness of H centimeters in a perpendicular direction to the first surface (10a). The semiconductor layer (20) contains an epitaxially grown silicon carbide with an off angle $\theta$ provided relative to a (0001) face of the substrate (10). The semiconductor layer (20) includes k pieces of basal plane dislocation (BPD) per one square centimeter viewed in the perpendicular direction. When $S = (1/2) \times H^2/(\tan\theta (\sin\theta \times \tan 30°))$ square centimeters, $k \times S < 0.075$ square centimeters is satisfied.

FIG. 1A

## Description

FIELD

Embodiments described herein relate generally to a semiconductor substrate and a semiconductor device.

BACKGROUND

Silicon carbide (SiC) has excellent physical properties exhibiting 3 times the band gap, approximately 10 times the breakdown field strength, and approximately 3 times the thermal conductivity compared to silicon (Si). Utilizing these properties of SiC allows a semiconductor device having excellent low-loss and high temperature operation to be realized. Semiconductor substrates containing an SiC substrate (bulk substrate) and a semiconductor layer in which an SiC is epitaxially grown on the substrate are normally used as semiconductor substrates used for manufacturing semiconductor devices made of SiC.

In an SiC semiconductor layer, a technique for step flow growth by inclining the (0001) face of the substrate is applied to obtain a desired polytype by epitaxially growing the SiC on the substrate. When forming the semiconductor layer using step flow growth described above, basal plane dislocation is propagated in a step flow direction on the semiconductor layer from the substrate. In a semiconductor device using an SiC semiconductor substrate, it is critical to suppress degradation of characteristics caused by basal plane dislocation.

BRIEF DESCRIPTION OF THE DRAWINGS

FIG. 1A and FIG. 1B are schematic views illustrating a semiconductor substrate according to a first embodiment;

FIG. 2 is a schematic cross-sectional view illustrating generation of a defect;

FIG. 3A and FIG. 3B are schematic plan views illustrating an increase in the stacking fault;

FIG. 4 is a diagram showing a change in current-voltage characteristics due to the number of stacking faults;

FIG. 5 is a diagram showing an example of characteristic fluctuation due to the number of stacking faults;

FIG. 6A and FIG. 6B are schematic views for describing the area of the stacking fault;

FIG. 7A to FIG. 7C are schematic views for describing the area of the stacking fault;

FIG. 8 is a drawing showing a change over time in the forward voltage;

FIG. 9 is schematic cross-sectional view illustrating an example of the semiconductor device according to the second embodiment; and

FIG. 10 is schematic cross-sectional view illustrating an example of the semiconductor device according to the third embodiment.

DETAILED DESCRIPTION

In general, according to one embodiment, a semiconductor substrate includes a substrate and a semiconductor layer. The substrate has a first surface and containing a silicon carbide. The semiconductor layer is provided on the first surface. The semiconductor layer has a thickness of H centimeters in a perpendicular direction to the first surface. The semiconductor layer contains an epitaxially grown silicon carbide with an off angle $\theta$ provided relative to a (0001) face of the substrate. The semiconductor layer includes k pieces of basal plane dislocation per one square centimeter viewed in the perpendicular direction. When $S = (1/2) \times H^2/(\tan\theta(\sin\theta \times \tan30°))$ square centimeters, $k \times S < 0.075$ square centimeters is satisfied.

Various embodiments will be described hereinafter with reference to the accompanying drawings. In the following description, the same reference numeral is applied to the same member, and for members that have been described once, the description is omitted as appropriate. Also, in the following description, the n+, n, n- and p+, p, and p- symbols indicating the conductivity type show relative high and low impurity concentrations in the conductivity types. In other words, n+ has a relatively higher n-type impurity concentration than n, and n- has a relatively lower n-type impurity concentration than n. Further, p+ has a relatively higher p-type impurity concentration than p, and p- has a relatively lower p-type impurity concentration than p.

(First Embodiment)

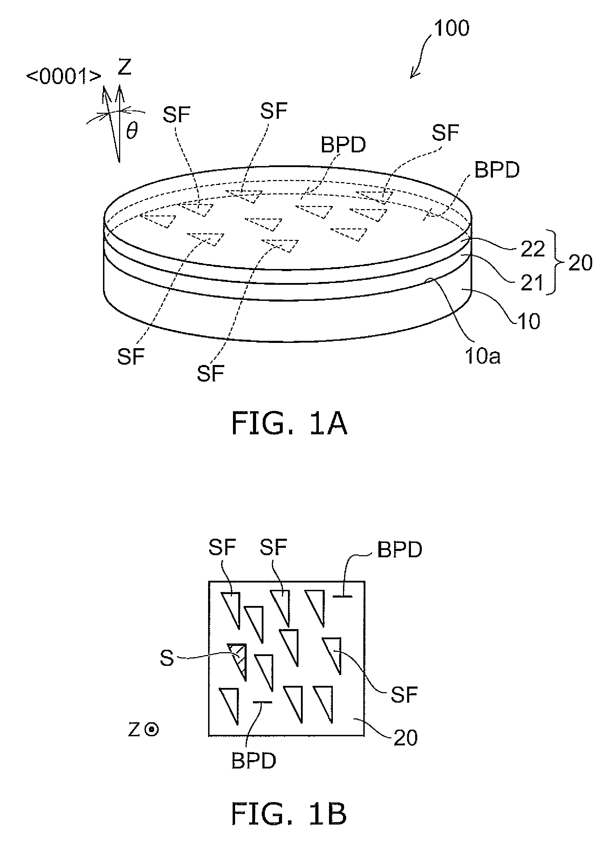

FIGS. 1A and 1B are schematic views illustrating a semiconductor substrate according to a first embodiment.

FIG. 1A is a schematic perspective view illustrating a semiconductor substrate 100 according to the first embodiment. FIG. 1B is a schematic plan view illustrating a defect in the unit area.

As illustrated in FIG. 1A, the semiconductor substrate 100 according to this embodiment includes a substrate 10 and a semiconductor layer 20. The substrate 10 has a first surface 10a. The substrate 10 contains SiC. The substrate 10 is an SiC substrate having, for example, a 4H polytype. The substrate 10 may have either a 2H or a 6H polytype. The first surface 10a is a surface having a predetermined off angle $\theta$ relative to the (0001) face of the SiC crystal. The first surface 10a is, for example, inclined by only the off angle $\theta$ in a <11-20> direction relative to the (0001) face of the SiC crystal. Any of, for example, 2°, 4°, or 8° can be used as the off angle $\theta$.

The substrate 10 is formed, for example, by a sublimation method or a liquid phase growth method. Basal plane dislocation (BPD) occurs in a random direction in the substrate 10.

The semiconductor layer 20 is provided on the first surface 10a of the substrate 10. The semiconductor layer 20 has a thickness of H centimeters (cm) in a direction perpendicular to the first surface 10a (referred to as the Z direction). The semiconductor layer 20 contains a crystal grown SiC with the off angle θ provided on the (0001) face of the substrate 10.

The semiconductor layer 20 is formed by epitaxial growth on the first surface 10a of the substrate 10. The semiconductor layer 20 is formed by step flow growth by inclining the substrate 10 by only the off angle θ. Basal plane dislocation (BPD) is propagated to the semiconductor layer 20 in the step flow direction that exists in the substrate 10 in step flow growth. Basal plane dislocation (BPD) that occurs on the semiconductor layer 20 extends linearly in a direction of the step flow growth with the basal plane dislocation (BPD) of the substrate 10 as a starting point. Basal plane dislocation (BPD) in the semiconductor layer 20 extends in, for example, a <11-20> direction along the (0001) face.

A buffer layer (not illustrated) may be provided between the substrate 10 and the semiconductor layer 20. The buffer layer is an n-type semiconductor layer having a higher impurity concentration than the impurity concentration of the semiconductor layer 20. It is known that by providing a buffer layer, basal plane dislocation (BPD) hardly remains in the semiconductor layer 20 because much of the basal plane dislocation (BPD) is converted to threading edge dislocation (TED) within the buffer layer. However, not all of the basal plane dislocation (BPD) is converted to threading edge dislocation (TED). The unconverted remaining pieces of basal plane dislocation (BPD) cause a degradation in the characteristics of the device.

The semiconductor layer 20 may include an n-type semiconductor region 21 and a p-type semiconductor region 22 that contacts the n-type semiconductor region 21. When the conductivity type of the substrate 10 is an n-type, the stacking order on the substrate 10 is the n-type semiconductor region 21 and then the p-type semiconductor region 22. When the substrate 10 has a p-type conductivity type, the stacking order on the substrate 10 is the p-type semiconductor region 22 and then the n-type semiconductor region 21.

The semiconductor layer 20, as illustrated in FIG. 1 B, includes k pieces of basal plane dislocation (BPD) per square centimeter ($cm^2$) as viewed in the Z direction. The basal plane dislocation (BPD) may become the starting point for generating a stacking fault (SF). The stacking fault (SF) is formed in a triangular shape by expanding from the basal plane dislocation (BPD).

In this embodiment, the reference value of the total area viewed in the Z direction of the stacking fault (SF) included per 1 $cm^2$ viewed in the Z direction of the semiconductor layer 20 is $S_0 cm^2$. Further, one area S $cm^2$ viewed in the Z direction of the stacking fault (SF) becomes $S = (1/2) \times H^2/(\tan\theta(\sin\theta \times \tan 30°))$. In this case, the semiconductor substrate 100 according to this embodiment satisfies $k \times S < So$. In this embodiment, for example, $S_0$ is 0.075 $cm^2$.

Satisfying $k \times S < So$ allows characteristic degradation of the semiconductor device formed using the semiconductor substrate 100 to be suppressed. For example, degradation of a forward voltage $V_f$ is suppressed in a diode formed using the semiconductor substrate 100.

Here, generation of defects and effects of defects will be described.

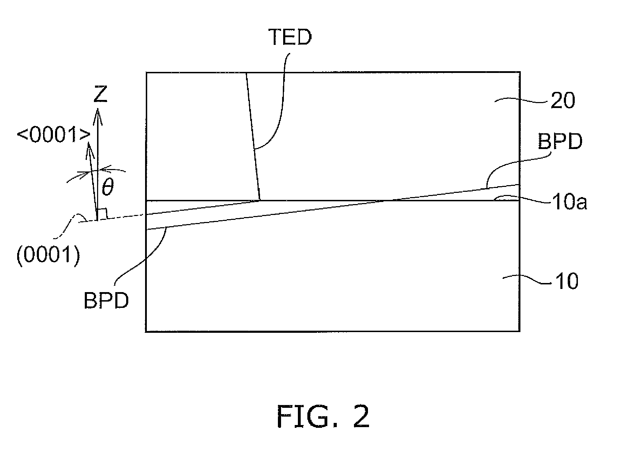

FIG. 2 is a schematic cross-sectional view illustrating generation of a defect.

As illustrated in FIG. 2, when the semiconductor layer 20 is epitaxially grown on the first surface 10a of the substrate 10 with the off angle θ being provided on the substrate 10, a portion of the basal plane dislocation (BPD) that exists in a plurality in the substrate 10 is converted to threading edge dislocation (TED) at an interface between the substrate 10 and the semiconductor layer 20. Further, another portion of the basal plane dislocation (BPD) in the substrate 10 is propagated to the semiconductor layer 20. For example, when n pieces (n is a natural number) of basal plane dislocation (BPD) exist in the substrate 10, m pieces (n > m: m is a natural number) of the n pieces are converted to threading edge dislocation (TED), and (n-m) pieces of basal plane dislocation (BPD) are propagated as is.

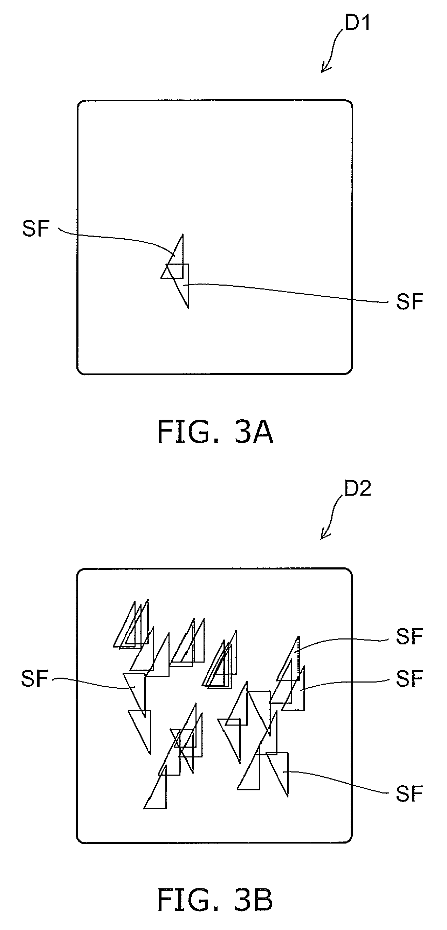

FIGS. 3A and 3B are schematic plan views illustrating an increase in the stacking fault.

FIG. 3A illustrates a device D1 having few stacking fault (SF), and FIG. 3B illustrates a device D2 having many stacking faults (SF). Here, the devices D1 and D2 are PiN diodes.

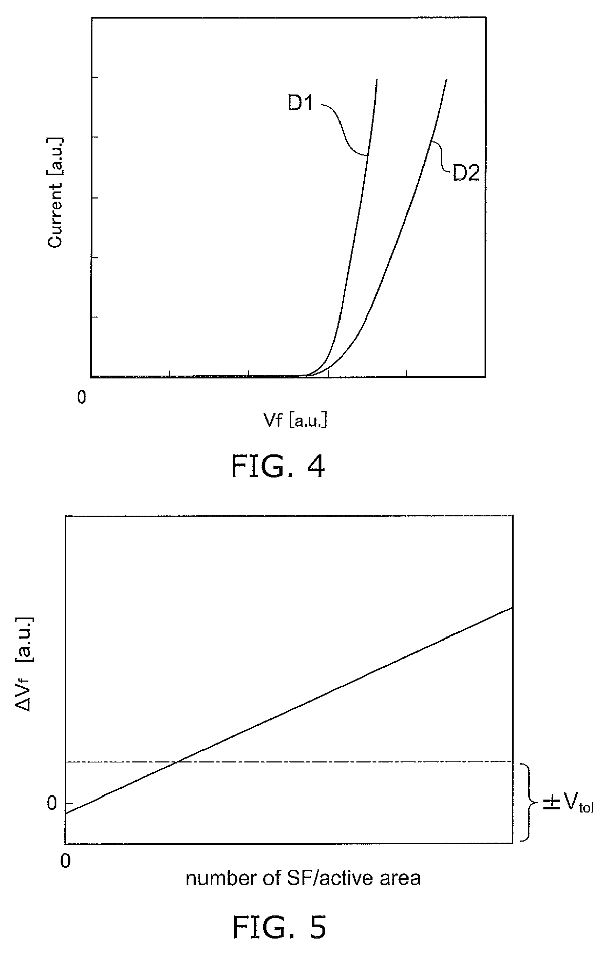

FIG. 4 is a diagram showing a change in current-voltage characteristics due to the number of stacking faults.

In FIG. 4, the horizontal axis represents the forward applied voltage $V_f$ and the vertical axis represents the current. FIG. 4 shows the characteristics of the device D1 illustrated in FIG. 3A and the characteristics of the device D2 illustrated in FIG. 3B.

The stacking faults (SF), as illustrated in FIGS. 3A and 3B, expand from the basal plane dislocation (BPD). It is considered that one stacking fault (SF) expands from one basal plane dislocation (BPD). As shown in FIG. 4, the current-voltage characteristics of the device D1 having few stacking faults (SF) illustrated in FIG. 3A are different from the current-voltage characteristics of the device D2 having many stacking faults (SF) illustrated in FIG. 3B. In other words, in the device D1, more current flows than the device D2 under the same forward voltage $V_f$. The stacking fault (SF) acts as a high-resistivity region in the device D1 and the device D2. Therefore, the device D1 having few stacking faults (SF) has lower on-voltage than the device D2 having many stacking faults (SF).

The area of the stacking faults (SF) may increase due to recombination energy between the electrons and holes in the semiconductor layer 20. In other words, in the devices D1 and D2, the increase in the area of the stacking faults (SF) over time may generate fluctuation in the characteristics.

FIG. 5 is a diagram showing an example of characteristic fluctuation due to the number of stacking faults.

In FIG. 5, the horizontal axis represents the number of stacking faults (SF) in the active region of a PiN diode, and the vertical axis represents fluctuation $\Delta V_f$ of the forward voltage $V_f$. Here, the fluctuation $\Delta V_f$ of the forward voltage $V_f$ is shown for when a PiN diode having a normal breakdown voltage is powered for a fixed time. The number of pieces of basal plane dislocation (BPD) in the active region of the PiN diode is measured by the number of stacking faults (SF) of an image displayed by electro luminescence (EL) or photo luminescence (PL). In FIG. 5, a relationship that can be assumed from a plurality of measurement points is shown by a direct line.

As shown in FIG. 5, a certain degree of positive relationship can be read between the $\Delta V_f$ and the number of stacking faults (SF). Here, a difference occurs in the forward voltage $V_f$ when a plurality of stacking faults (SF) overlap in the Z direction and when they do not overlap. It is considered that the area viewed in the Z direction for the stacking faults (SF) has a significant effect on the forward voltage $V_f$.

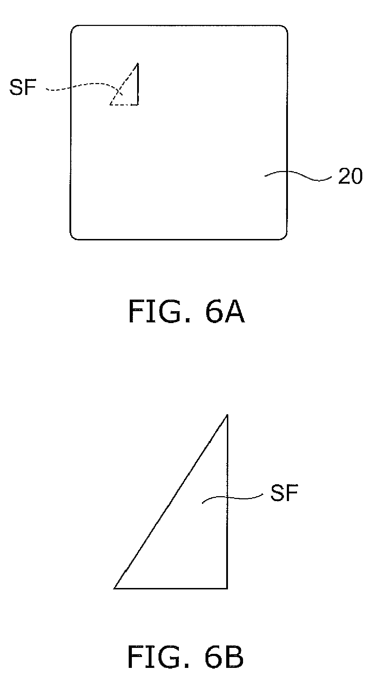

FIGS. 6A and 6B are schematic views for describing the area of the stacking fault.

FIG. 6A illustrates an example of a stacking fault (SF) displayed by EL, and FIG. 6B illustrates a shape viewed in the Z direction of the stacking faults (SF). As illustrated in FIG. 6A, a portion of the image of the stacking fault (SF) appears in the screen image of the device displayed by EL. A portion of the image near the surface of the semiconductor layer 20 of the stacking fault (SF) appears on the EL screen image. The shape of the stacking fault (SF) can be assumed from this image.

FIG. 6B is a magnified view of the shape of the stacking fault (SF) assumed from the portion of the image of the stacking fault (SF) illustrated in FIG. 6A. The stacking fault (SF) is formed in a right triangle shape along the (0001) face. One of the acute angles of the right triangle of the stacking fault (SF) viewed from the <0001> direction perpendicular to the (0001) face is approximately 30°, and the other acute angle is approximately 60°. Because the off angle $\theta$ is provided in the Z direction relative to the <0001> direction, the shape of the stacking fault (SF) viewed from the Z direction becomes a shape of the right triangle of the stacking fault (SF) projected on a face perpendicular to the Z direction (see FIG. 6B).

The inventors discovered that characteristic fluctuation (degradation over time) of the device is suppressed by satisfying kxS < So in the semiconductor substrate 100 based on the relationship between the number of stacking faults (SF) and the fluctuation $\Delta V_f$ of the characteristic ($V_f$).

Next, the condition kxS < So in the semiconductor substrate 100 is described.

The number of pieces $k_{max}$ of the basal plane dislocation (BPD) in the semiconductor substrate 100 is defined where the fluctuation of characteristics (for example, the fluctuation $\delta V_f$ of the forward voltage $V_f$) of the device formed using the semiconductor substrate 100 falls within a predetermined fixed range. Here, the tolerance of the fluctuation $\Delta V_f$ is $V_{tol}$.

By setting the tolerance $V_{tol}$, the number of stacking faults (SF) falling within the range of $\pm V_{tol}$ with $\Delta V_f = 0$ (no fluctuation) as the center can be determined, for example, from the relationship between the fluctuation $\Delta V_f$ and the number of stacking faults (SF) as shown in FIG. 5.

Based on one example of experiments performed by the inventors concerning the relationship between the fluctuation $\Delta V_f$ and the number of this stacking faults (SF) described above, when $V_{tol}$ is set to, for example, 0.1 V, the number of stacking faults (SF) in the active region of the device (PiN diode) becomes approximately 5 pieces. As shown in FIG. 5, when the plots showing the relationship between the fluctuation $\Delta V_f$ and the number of stacking faults (SF) are scattered, the relationship determined by the least square method, or the like, may be used for each plot.

The number of pieces of the basal plane dislocation (BPD) is considered to match the number of stacking faults (SF). Accordingly, the number of pieces of the basal plane dislocation (BPD) in the active region of the device is also approximately 5 pieces which is the same as the number of stacking faults (SF). The area of the active region of the device used in the experiment is approximately 0.16 cm$^2$. Accordingly, the number of pieces $k_{max}$ of the basal plane dislocation (BPD) per 1 cm$_2$ is approximately 30 pieces.

Next, the reference value So of the total area viewed in the Z direction of the stacking fault (SF) included per 1 cm$_2$ viewed in the Z direction will be described.

The reference value So is the product of the number of pieces $k_{max}$ of the basal plane dislocation (BPD) fallen within the acceptable range of the fluctuation $\Delta V_f$ and the area S per one stacking fault (SF) viewed in the Z direction.

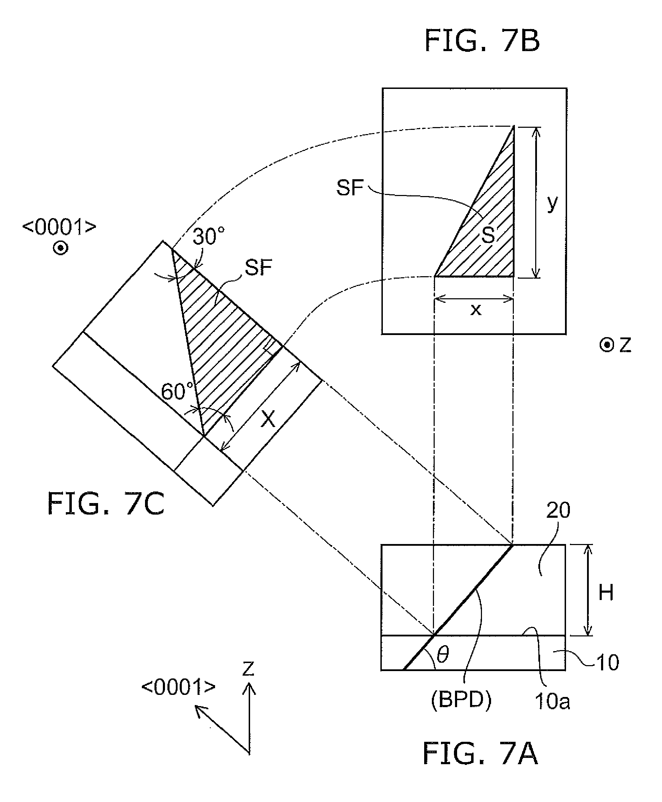

FIGS. 7A to 7C are schematic views for describing the area of the stacking fault.

FIG. 7A is a schematic cross-sectional view viewed in a direction perpendicular to the Z direction. FIG. 7B is a schematic plan view viewed in the Z direction. FIG. 7C is a schematic plan view viewed from the <0001> direction perpendicular to the (0001) face of the stacking fault (SF) face.

Here, the area S per one stacking fault (SF) viewed in the Z direction is the area of the hatched portion of FIG. 7B.

As illustrated in FIG. 7A, the semiconductor layer 20 provided on the first surface 10a of the substrate 10 has a thickness of H cm in the Z direction. Further, the semiconductor layer 20 includes a portion which is the basal plane dislocation (BPD) having a length of X cm. Also, the off angle of the substrate 10 is θ.

As illustrated in FIG. 7C, the shape viewed from the <0001> direction of the stacking fault (SF) becomes a right triangle having acute angles of 30° and 60° and a right angle.

Here, as illustrated in FIG. 7B, the length of a side that corresponds to the basal plane dislocation (BPD) is x and the length of a side that extends along the semiconductor layer 20 is y for the triangular shape viewed in the Z direction of the stacking fault (SF). The lengths x and y are defined as follows.

$$x = X/\tan30° = H/(\sin\theta \cdot \tan30°)$$

$$y = X\cos\theta = H\cos\theta/\sin\theta = H/\tan\theta$$

As described above, the area S viewed in the Z direction of one stacking fault (SF) when the off angle θ of the substrate 10 and the thickness H of the semiconductor layer 20 are given, is defined as follows.

$$S = (1/2) \times H^2/(\tan\theta(\sin\theta \cdot \tan30°))$$

From the above definition of the area S, the area S can be determined once the thickness H of the semiconductor layer 20 and the off angle θ of the substrate 10 are defined. As an example, when the thickness H of the semiconductor layer 20 is 38 μm (0.0038 cm), and the off angle θ of the substrate 10 is 4°, the area S is approximately 0.0025 cm². Accordingly, the total area So of the 30 pieces of stacking faults (SF) per 1 cm² is 0.075 cm².

In this manner, in the semiconductor substrate 100 of this embodiment, if the total area viewed in the Z direction of the stacking fault (SF) per 1 cm² viewed in the Z direction does not exceed 0.075 cm², then the fluctuation of the characteristic $V_f$ of the device formed using the semiconductor substrate 100 falls within 0.1 V. In other words, when the number of pieces k of the basal plane dislocation (BPD) per 1 cm² viewed in the Z direction of the semiconductor substrate 100 satisfies k×S < So, characteristic fluctuation of the device is effectively suppressed.

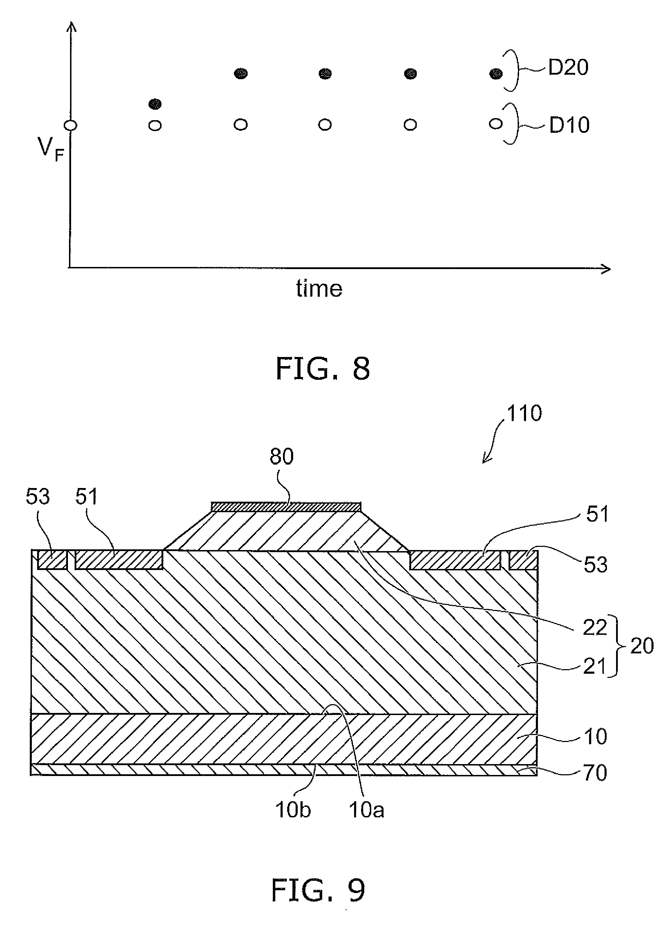

FIG. 8 is a drawing showing a change over time in the forward voltage.

FIG. 8 shows a change over time in the forward voltage ($V_f$) for the devices D10 and D20. In FIG. 8, the horizontal axis represents the time, and the vertical axis represents the forward voltage ($V_f$). The device D10 is a device fabricated using the semiconductor substrate 100 according to this embodiment. The device D20 is a device fabricated using a semiconductor substrate that does not satisfy k×S < So. Here, $S_0$ is 0.075 cm².

As shown in FIG. 8, it can be understood that a change over time in the forward voltage ($V_f$) is suppressed in the device D10 using the semiconductor substrate 100 according to this embodiment, compared to the device D20.

Here, examples of tolerance $V_{tol}$ for the fluctuation $\Delta V_f$ and the reference value So are described below.

When $V_{tol}$ = 0.15 V, reference value So = 0.12 cm².

When $V_{tol}$ = 0.2 V, reference value So = 0.13 cm².

When $V_{tol}$ = 0.25 V, reference value So = 0.15 cm².

When $V_{tol}$ = 0.3 V, reference value So = 0.16 cm².

When $V_{tol}$ = 0.35 V, reference value So = 0.17 cm².

The semiconductor substrate 100 of this embodiment is effective when the diameter viewed in the Z direction is greater than 4 inches. Furthermore, the semiconductor substrate 100 is particularly effective when the diameter viewed in the Z direction is not less than 6 inches, and the off angle θ is not more than 2°. When the diameter of the semiconductor substrate 100 is not less than 6 inches, a device having a large chip size can be formed using the semiconductor substrate 100. For example, when the diameter of the semiconductor substrate 100 is 6 inches, a device having a chip size of one side of approximately not less than 5 mm and not more than 6 mm (if the device is a diode, then a device having not less than 50 amps (A) as the tolerance of the forward current of the diode) is formed. With such a chip size, if the off angle θ of the substrate 10 is not more than 2°, then the area of the stacking fault (SF) easily becomes greater compared to when the diameter of the semiconductor substrate 100 is less than 6 inches. Therefore, using the semiconductor substrate 100 that satisfies the above relationship (k×S < So) when the diameter of the semiconductor substrate 100 is not less than 6 inches and the off angle θ is not more than 2° allows fluctuation in characteristics to be sufficiently suppressed even in a device having a large chip size.

(Second Embodiment)

Next, a semiconductor device according to a second embodiment will be described.

FIG. 9 is schematic cross-sectional view illustrating an example of the semiconductor device according to the second embodiment.

As illustrated in FIG. 9, the semiconductor device 110 according to the second embodiment is a device that uses the semiconductor substrate 100 according to the first embodiment. The semiconductor device 110 is, for example, a PiN diode made of SiC.

The semiconductor substrate 100 used in the semiconductor device 110 includes the substrate 10 and the semiconductor layer 20. The semiconductor substrate 100 satisfies $k \times S < So$ as described above.

The semiconductor layer 20 includes the n-type semiconductor region 21 provided on the substrate 10 and the p-type semiconductor region 22 provided on the n-type semiconductor region 21 and that contacts the n-type semiconductor region 21.

The substrate 10 is an $n^+$ type semiconductor region. The substrate 10 contains, for example, an $n^+$ type SiC. In this embodiment, a hexagonal crystal SiC (for example, 4H-SiC) is contained in the substrate 10. The substrate 10 is an SiC bulk substrate fabricated, for example, by a sublimation method.

The substrate 10 has the first surface 10a. The first surface 10a of the substrate 10 is a surface of a wafer that contains SiC. The first surface 10a is also a boundary face between the substrate 10 and the semiconductor layer 20. In this embodiment, the first surface 10a of the substrate 10 is inclined by greater than 0° but not more than 8° relative to the (0001) face which is the SiC face of the hexagonal crystal. For example, the substrate 10 is an off substrate such as a 2° off substrate, 4° off substrate, or 8° off substrate. Here, the surface of the SiC substrate 10 may be a Si face or a C face. Basal plane dislocation that resides within the basal plane exists within the substrate 10 which is the off substrate.

The substrate 10 is doped with n-type impurities. The impurity concentration of the substrate 10 is, for example, not less than $1 \times 10^{18}$ cm$^{-3}$ and not more than $1 \times 10^{20}$ cm$^{-3}$. In this embodiment, the impurity concentration of the substrate 10 is approximately $5 \times 10^{8}$ cm$^{-3}$.

The n-type semiconductor region 21 is a semiconductor region that contains an n-type SiC. The n-type semiconductor region 21 is formed by epitaxial growth on the first surface 10a of the substrate 10 and has a crystal structure equivalent to that of the substrate.

The thickness of the n-type semiconductor region 21 is determined by the design of the breakdown voltage characteristic and other characteristics of the semiconductor device 110 and is, for example, not more than about 200 micrometers ($\mu$m). The n-type semiconductor region 21 is doped with n-type impurities. The impurity concentration of the n-type semiconductor region 21 is less than the impurity concentration of the substrate 10. The impurity concentration of the n-type semiconductor region 21 is, for example, not less than $8 \times 10^{14}$ cm$^{-3}$ and not more than $1 \times 10^{17}$ cm$^{-3}$.

The p-type semiconductor region 22 is a semiconductor region made of a $p^+$ type SiC. The p-type semiconductor region 22 is formed by epitaxial growth on the n-type semiconductor region 21. The thickness of the p-type semiconductor region 22 is, for example, approxi-

mately several $\mu$m. The p-type semiconductor region 22 is doped with p-type impurities. The impurity concentration of the p-type semiconductor region 22 is, for example, not less than $1 \times 10^{16}$ cm$^{-3}$ and not more than $5 \times 10^{19}$ cm$^{-3}$.

The p-type semiconductor region 22 is provided, for example, on a portion of the n-type semiconductor region 21. In other words, the p-type semiconductor region 22 is formed in a mesa shape.

A termination structure region 51 is provided on the n-type semiconductor region 21 around the p-type semiconductor region 22 formed in a mesa shape. The termination structure region 51 is provided, for example, so as to surround continuously around the p-type semiconductor region 22. Further, a channel stopper layer 53 is provided so as to be separated from the termination structure region 51 on the n-type semiconductor region 21 around the termination structure region 51. The channel stopper layer 53 is provided, for example, so as to surround around the termination structure region 51.

The termination structure region 51 is, for example, a $p^-$ type semiconductor region. The termination structure region 51 is, for example, a junction termination extension (JTE). The termination structure region 51 may be a RESURF layer, a field limiting ring (FLR), or a field plate (FP) instead of a JTE. The termination structure region 51 is designed to improve breakdown voltage by mitigating electric field concentration in the termination at the time of reverse bias.

A cathode electrode 70, which is a first electrode, is provided on a second surface 10b on a side opposite the first surface 10a of the substrate 10. The cathode electrode 70 conducts with the substrate 10. The cathode electrode 70 is in ohmic contact with the substrate 10. Further, an anode electrode 80, which is a second electrode, is provided on the p-type semiconductor region 22. The anode electrode 80 conducts with the p-type semiconductor region 22. The anode electrode 80 is in ohmic contact with the p-type semiconductor region 22.

In this type of semiconductor device 110, the substrate 10 is an N (n-type semiconductor region) of the PiN diode. The n-type semiconductor region 21 is an i (intrinsic semiconductor region) of the PiN diode. The p-type semiconductor region 22 is a P (p-type semiconductor region) of the PiN diode.

Next, the operation of the semiconductor device 110 will be described.

First, an operation for when (forward) voltage is applied so that the anode electrode 80 becomes positive relative to the cathode electrode 70 of the semiconductor device 110 will be described. When the forward voltage is applied, electrons and holes that exceed the built-in potential flow via the p-n junction plane that exists on the interface between the p-type semiconductor region 22 having a $p^+$ type and the n-type semiconductor region 21 having an $n^-$ type. By this, a current flows to the semiconductor device 110 (forward operation).

Next, an operation for when (backward) voltage is applied so that the anode electrode 80 becomes negative relative to the cathode electrode 70 of the semiconductor device 110 will be described. When the backward voltage is applied, a depletion layer spreads primarily to an i layer side of the p-n junction plane, and almost no current flow to the semiconductor device 110 (backward operation).

The semiconductor device 110 is formed using the semiconductor substrate 100 according to the first embodiment. Therefore, fluctuation in characteristics caused by the stacking faults (SF) is suppressed in the semiconductor device 110. For example, an increase in on-voltage, or a decrease in breakdown voltage, due to an occurrence of a stacking fault (SF) is suppressed. Therefore, the initial on-voltage and breakdown voltage can be maintained for a long period of time in the semiconductor device 110.

(Third Embodiment)

Next, a semiconductor device according to a third embodiment will be described.

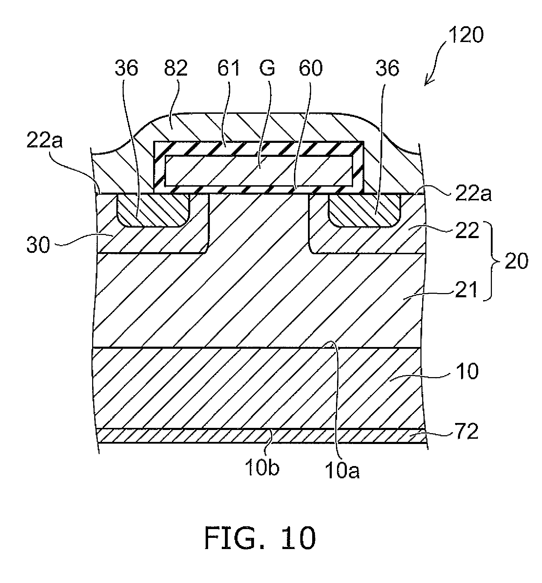

FIG. 10 is schematic cross-sectional view illustrating an example of the semiconductor device according to the third embodiment.

As illustrated in FIG. 10, the semiconductor device 120 according to the third embodiment is a device that uses the semiconductor substrate 100 according to the first embodiment. The semiconductor device 120 is, for example, an insulated gate bipolar transistor (IGBT) made of SiC.

The semiconductor substrate 100 used in the semiconductor device 120 includes the substrate 10 and the semiconductor layer 20. The semiconductor substrate 100 satisfies $k \times S < So$ as described above.

The semiconductor device 120 includes the substrate 10, the n-type semiconductor region 21, the p-type semiconductor region 22, an emitter region 36, a gate insulating film 60, a gate electrode G, a collector electrode 72 which is a first electrode, and an emitter electrode 82 which is a second electrode.

In the semiconductor device 120, the conductivity type of the substrate 10 is $p^+$ type. In the semiconductor device 120, the substrate 10 is, for example, a $p^+$ type SiC bulk substrate. In the semiconductor device 120, the n-type semiconductor region 21 is a semiconductor region that contains an $n^-$ type SiC. The n-type semiconductor region 21 is a drift layer of the IGBT.

In the semiconductor device 120, the p-type semiconductor region 22 is a semiconductor region that contains a $p^-$ type SiC. The p-type semiconductor region 22 is formed on a portion of the n-type semiconductor region 21 and has a predetermined crystal structure. The p-type semiconductor region 22 is a base region of the IGBT. In the semiconductor device 120, a plurality of p-type semiconductor regions 22 is provided. The plurality of p-type semiconductor regions 22 is disposed so as to be mutually separated on the n-type semiconductor region 21.

The emitter region 36 is a semiconductor region that contains an $n^+$ type SiC. In the semiconductor device 120, a plurality of emitter regions 36 is provided. Each of the plurality of emitter regions 36 is respectively provided for each of the plurality of p-type semiconductor region 22. The emitter region 36 is formed on a portion of the p-type semiconductor region 22.

The gate insulating film 60 is provided at least on a surface 22a of the p-type semiconductor region 22. The gate electrode G is provided on the gate insulating film 60. The gate electrode G is provided on two adjacent p-type semiconductor regions 22 with the gate insulating film 60 therebetween. An insulating film 61 is provided between the gate electrode G and the emitter electrode 82.

The emitter electrode 82 contacts the emitter region 36. The emitter electrode 82 is in ohmic contact with the emitter region 36. In this embodiment, the emitter electrode 82 also contacts the p-type semiconductor region 22. By this, the emitter electrode 82 functions as a common electrode for the p-type semiconductor region 22 and the emitter region 36 of the IGBT.

The collector electrode 72 contacts the second surface 10b of the substrate 10. The collector electrode 72 is in ohmic contact with the substrate 10.

Next, the operation of the semiconductor device 120 will be described.

When a voltage of not less than a threshold value is applied to the gate electrode G while a positive voltage relative to the emitter electrode 82 is applied to the collector electrode 72, an inversion layer (channel) is formed near the interface with the gate insulating film 60 in the p-type semiconductor region 22, which is a base region. By this, electrons are injected from the emitter region 36 into the p-type semiconductor region 22 (base region) via the channel, and the semiconductor device 120 enters an ON state. Also, at this time, holes are injected from the collector electrode 72 into the n-type semiconductor region 21 (drift region). The holes injected into the drift region pass through the base region and flow to the emitter electrode 82. In the semiconductor device 120, in the ON state, holes are injected from the collector electrode 72 into the drift region to generate conductivity modulation which reduces resistance in the drift region.

Meanwhile, if the voltage applied to the gate electrode G is less than the threshold value, the channel disappears. By this, the semiconductor device 120 enters an OFF state, and current that flows from the collector electrode 72 to the emitter electrode 82 is blocked.

The semiconductor device 120 is formed using the semiconductor substrate 100 according to the first embodiment. Therefore, fluctuation in characteristics caused by stacking faults (SF) is suppressed in the semiconductor device 120. For example, an increase in on-voltage, or a decrease in breakdown voltage, due to an occurrence of a stacking fault (SF) is suppressed. Therefore, the initial on-voltage and breakdown voltage can be maintained for a long period of time in the semiconductor device 120.

As described above, the semiconductor substrate and the semiconductor device according to the embodiments can suppress degradation of characteristics caused by basal plane dislocation.

The embodiments were described above with reference to specific examples. However, the embodiments are not limited to these specific examples. For example, in the above embodiments, a PiN diode and an IGBT were described as examples of the semiconductor device, but various semiconductor devices having a p-n junction region can be applied such as a PN diode, a bipolar junction transistor, a thyristor, a gate-turn-off thyristor, and the like.

Also, these examples to which a person skilled in the art to which the invention pertains has added design modifications as appropriate are also included in the scope of the invention, provided the features of the embodiments are included. Each of the elements included in the examples described above and their arrangement, material, conditions, shape, size, and the like is not limited to the examples described above, and can be varied as appropriate.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the invention.

**Claims**

1. A semiconductor substrate (100), comprising:

   a substrate (10) having a first surface (10a) and containing a silicon carbide; and
   a semiconductor layer (20) provided on the first surface (10a), the semiconductor layer (20) having a thickness of H centimeters in a perpendicular direction to the first surface (10a), and the semiconductor layer (20) containing an epitaxially grown silicon carbide with an off angle θ provided relative to a (0001) face of the substrate (10),
   the semiconductor layer (20) including k pieces of basal plane dislocation (BPD) per one square centimeter viewed in the perpendicular direction, and
   when $S = (1/2) \times H^2/(\tan\theta(\sin\theta \times \tan30°))$ square centimeters,

   $k \times S < 0.075$ square centimeters being satisfied.

2. The semiconductor substrate (100) according to claim 1, wherein the semiconductor layer (20) includes an n-type semiconductor region (21) and a p-type semiconductor region (22) contacting the n-type semiconductor region (21).

3. The semiconductor substrate (100) according to claim 1, wherein a diameter viewed in the direction of the substrate (10) is greater than 4 inches.

4. The semiconductor substrate (100) according to claim 1, wherein the off angle θ is not more than 2 degrees.

5. A semiconductor device (110), comprising:

   a substrate (10) having a first surface (10a) and containing a silicon carbide; and
   a semiconductor layer (20) provided on the first surface (10a) of the substrate (10), the semiconductor layer (20) having a thickness of H centimeters in a perpendicular direction to the first surface (10a), and the semiconductor layer (20) containing an epitaxially grown silicon carbide with an off angle θ provided relative to a (0001) face of the substrate (10),
   the semiconductor layer (20) including an n-type semiconductor region (21) and a p-type semiconductor region (22) contacting the n-type semiconductor region (21),
   the semiconductor layer (20) including k pieces of basal plane dislocation (BPD) per one square centimeter viewed in the direction, and
   when $S = (1/2) \times H^2/(\tan\theta(\sin\theta \times \tan30°))$ square centimeters,
   $k \times S < 0.075$ square centimeters being satisfied.

6. The device (110) according to claim 5, wherein the semiconductor layer (20) includes a diode, and an amount of change over time in a forward voltage of the diode is within 0.1 volts.

7. The device (110) according to claim 5, wherein a tolerance of a forward current of the diode is not less than 50 amperes.

8. The device (110) according to claim 5, wherein the off angle θ is an angle inclined in a <11-20> direction of the substrate (10) relative to a (0001) face of the substrate (10).

9. The device (110) according to claim 5, wherein the silicon carbide of the substrate (10) has a polytype of any one of 2H, 4H, or 6H.

10. The device (110) according to claim 5, wherein the silicon carbide of the semiconductor layer (20) has a polytype of any one of 2H, 4H, or 6H.

**11.** The device (110) according to claim 5, wherein the semiconductor layer (20) has a region for recombining electrons and holes when applying power to the semiconductor layer (20).

**12.** The device (110) according to claim 5, wherein a concentration of impurities of the n-type semiconductor region (21) is lower than a concentration of impurities of the substrate (10).

**13.** The device (110) according to claim 12, wherein a concentration of impurities of the n-type semiconductor region (21) is not less than $8 \times 10^{14}$ cm$^{-3}$ and not more than $1 \times 10^{17}$ cm$^{-3}$, and a concentration of impurities of the substrate (10) is not less than $1 \times 10^{18}$ cm$^{-3}$ and not more than $1 \times 10^{20}$ cm$^{-3}$.

**14.** The device (110) according to claim 5, further comprising a termination structure region (51) provided around the p-type semiconductor region (22) and on the n-type semiconductor region (21).

**15.** The device (120) according to claim 5, wherein the conductivity type of the substrate (10) is a p type; further comprising:

an n-type emitter region (36) provided on a portion of the p-type semiconductor region (21); a gate insulating film (60) provided on the p-type semiconductor region (22); and a gate electrode (G) provided on the gate insulating film (36).

**16.** The device (120) according to claim 15, wherein a concentration of impurities of the substrate (10) is greater than a concentration of impurities of the p-type semiconductor region (22), and a concentration of impurities of the emitter region (36) is greater than a concentration of impurities of the n-type semiconductor region (21).

FIG. 1A

FIG. 1B

TED

Z

<0001>

θ

(0001)

BPD

BPD

20

10a

10

FIG. 2

D1

SF

SF

## FIG. 3A

D2

SF

SF

SF

SF

## FIG. 3B

FIG. 4

FIG. 5

SF

20

FIG. 6A

SF

FIG. 6B

FIG. 7B

FIG. 7C

FIG. 7A

FIG. 8

FIG. 9

FIG. 10